# EUROPEAN PATENT SPECIFICATION

(11) **EP 1 948 841 B1**
(45) Date of publication and mention of the grant of the patent: **29.04.2015**
(21) Application number: 06744168.3
(22) Date of filing: 08.06.2006
(51) Int. Cl.: C23C 16/40, C23C 16/18, C23C 16/455

(54) **CYCLOPENTADIENYL TYPE HAFNIUM AND ZIRCONIUM PRECURSORS AND USE THEREOF IN ATOMIC LAYER DEPOSITION**
HAFNIUM- UND ZIRKONVORLÄUFER VOM CYCLOPENTADIENYLTYP UND IHRE VERWENDUNG BEI DER ATOMLAGENABSCHEIDUNG
PRÉCURSEURS D'HAFNIUM ET DE ZIRCONIUM DE TYPE CYCLOPENTADIÉNYLE ET LEUR UTILISATION DANS LE DÉPÔT EN COUCHES ATOMIQUES

(30) Priority: 16.11.2005 GB 0523339
(43) Date of publication of application: 30.07.2008
(73) Proprietor: Sigma-Aldrich Co. LLC, St. Louis, MO 63103 (US)
(72) Inventor: HEYS, Peter, Crewe Cheshire CW2 6QE (GB); WILLIAMS, Paul, Bromborough Wirral CH62 2AY (GB); SONG, Fuquan, Eastham Wirral CH62 8EX (GB)
(74) Representative: Brown, David Leslie
(86) International application number: PCT/GB2006/002119
(87) International publication number: WO 2006/131751

(56) References cited:
- US-A1- 2005 148 743
- US-A1- 2006 079 394
- NIINISTO J ET AL: "Controlled growth of HfO2 thin films by atomic layer deposition from cyclopentadienyl-type precursor and water" JOURNAL OF MATERIALS CHEMISTRY R. SOC. CHEM UK, vol. 15, no. 23, 21 June 2005 (2005-06-21), pages 2271-2275, XP002397476 ISSN: 0959-9428 cited in the application
- NIINISTO J ET AL: "Structural and dielectric properties of thin ZrO2 films on silicon grown by atomic layer deposition from cyclopentadienyl precursor" JOURNAL OF APPLIED PHYSICS AIP USA, vol. 95, no. 1, 1 January 2004 (2004-01-01), pages 84-91, XP002397605 ISSN: 0021-8979
- CODATO SIMONE ET AL: "MOCVD growth and characterization of ZrO2 thin films obtained from unusual organo-zirconium precursors" ADV MATER; ADVANCED MATERIALS 1999 WILEY-VCH VERLAG BERLIN GMBH, WEINHEIM, GER, vol. 11, no. 11, 1999, pages 159-164, XP002397606
- H. G. ALT, C. E. DENNER: "zirconocene ethylene complexes" JOURNAL OF ORGANOMETALLIC CHEMISTRY, vol. 391, 17 July 1990 (1990-07-17), pages 53-60, XP002397607
- NIINISTO JAAKKO ET AL: "Processing of Y2O3 thin films by atomic layer deposition from cyclopentadienyl-type compounds and water as precursors" CHEM. MATER.; CHEMISTRY OF MATERIALS JUL 27 2004, vol. 16, no. 15, 27 July 2004 (2004-07-27), pages 2953-2958, XP002397608
- Tatsuya Nakano ET AL: "Meerwein-Ponndorf-Verley-type reduction of dicarbonyl compounds to hydroxy carbonyl compounds and .alpha.,.beta.-unsaturated carbonyl compounds to allylic alcohols catalyzed by zirconocene and hafnocene complexes", The Journal of Organic Chemistry, vol. 53, no. 16, 1 August 1988 (1988-08-01), pages 3752-3757, XP055138283, ISSN: 0022-3263, DOI: 10.1021/jo00251a016
- Edward J. Stoebenau ET AL: "Coordination of Alkenes and Alkynes to a Cationic d 0 Zirconocene Alkoxide Complex", Journal of the American Chemical Society, vol. 125, no. 11, 1 March 2003 (2003-03-01), pages 3222-3223, XP055138282, ISSN: 0002-7863, DOI: 10.1021/ja029963j

## Description

This invention concerns chemical vapour deposition, especially atomic layer deposition (ALD) and precursors therefor.

In ALD, thermal decomposition of the precursors is undesirable as the mechanism is purely a chemical reaction on the growth surface. Alternate precursors are applied with a self-limiting reaction depositing one monolayer at a time in an extremely uniform manner. Any thermal breakdown of the precursor means that the self-limiting growth is lost and so the layers formed are not good.

For ALD of hafnium based oxide materials, tetrakis(ethylmethyl)hafnium (IV) (hafnium methylethylamide, Hf(NEtMe)₄) is reportedly the best available precursor but is not sufficiently stable for use in ALD in practice.

An alternative hafnium precursor has been proposed, namely, bis(cyclopentadienyl) hafnium (IV) dimethyl (Cp₂HfMe₂). This precursor is, however, a solid having low volatility and so suffers from transport problems.

Niinisto J. et al. "Controlled growth of HfO2 thin films by atomic layer deposition from cyclopentadienyl-type precursor and water": Journal of Materials Chemistry R. Soc. Chem UK, vol. 15, no. 23, 21 June 2005, pages 2271 - 2275 describes deposition of HfO₂ thin films onto p-Si(100) substrates by atomic layer deposition (ALD) using Cp₂Hf(CH₃)₂ and water as precursors at 300 - 500°C.

Niinisto J. et al. "Structural and dielectric properties of thin ZrO2 films on silicon grown by atomic layer deposition from cyclopentadienyl precursor": Journal of Applied Physics AIP USA, vol. 95, no. 1, 1 January 2004, pages 84 - 91 describes deposition of ZrO₂ thin films with thicknesses below 20 nm onto Si(100) substrates by atomic layer deposition (ALD) at 350°C. The organometallic precursor Cp₂Zr(CH₃)₂ was used as the zirconium source and water or ozone was used as the oxygen source.

Codato Simone et al. "MOCVD growth and characterization of ZrO2 thin films obtained from unusual organo-zirconium precursors": Chemical Vapor Deposition, vol. 5, issue 4, 1999, pages 159 - 164 describes deposition of ZrO₂ thin films on polycrystalline alumina, glass, <100> silicon and stainless steel substrates by metal-organic chemical vapour deposition (MOCVD) using zirconium cyclopentadienyl derivatives as precursors, both in a flux of oxygen and an oxygen/water vapour mixture. High quality zirconia films with high growth rates were obtained by employing (C₅H₅)Zr(CH₃)₂.

H.G. Alt and C.E. Denner "Zirconocene ethylene complexes": Journal of Organometallic Chemistry, vol. 391, 17 July 1990, pages 53 - 60 describes the reaction of the ethylene complex Cp₂Zr(C₂H₄)(PMe₃) with a variety of substrates. This article specifically discloses the compounds bis(cyclopentadienyl)bis(methoxy) zirconium (IV), bis(cyclopentadienyl)bis(ethoxy) zirconium (IV), bis(cyclopentadienyl)methyl(methoxy) zirconium (IV).

Nakano, T. et al. "Meerwein-Ponndorf-Verley-Type Reduction of Dicarbonyl Compounds to Hydroxy Carbonyl Compounds and α,β-Unsaturated Carbonyl Compounds to Allylic Alcohols Catalyzed by Zirconocene and Hafnocene Complexes": J. Org. Chem., vol. 53, 1988, pages 3752-3757 discloses the compounds bis(cyclopentadienyl) bis(i-propoxy) hafnium (IV) and bis(cyclopentadienyl) bis(i-propoxy) zirconium (IV).

Stoebenau, E.J. et al. "Coordination of Alkenes and Alkynes to a Cationic d0 Zirconocene Alkoxide Complex": J. Am. Chem. Soc., vol. 125, pages 3222 to 3223 and Supplemental Information, pages S1 to S336 disclose the compounds bis(cylcopentadienyl) zirconium (IV) methyl t-butoxy and bis(methylcyclopentadienyl) zirconium (IV) methyl t-butoxy.

US 2005/0148743 and US 2006/0079394 disclose the compounds bis(n-propylcyclopentadienyl) bis(methoxy) hafnium (IV) and bis(n-propylcyclopentadienyl) bis(methoxy) zirconium (IV).

The present invention is defined in and by the appended claims. An object of this invention is to provide precursors suitable for chemical vapour deposition, especially ALD, of hafnium oxide and zirconium oxide and a method of depositing hafnium oxide or zirconium oxide.

According to a first aspect of the invention there is provided a use for a precursor in the atomic layer deposition (ALD) of hafnium oxide or zirconium oxide, wherein the precursor has the general formula:

(R¹Cp)₂M(R)₂ or (R⁶Cp)₂MR⁴R⁵ or Cp₂MR^{4a}R^{5a} or (R^{6a}Cp)₂MR^{4b}OR^{5b}

wherein Cp represents a cyclopentadienyl ligand, R¹ and R⁶ represent a substituting alkyl group, alkoxy group or amido group of the Cp ligand, R is an alkyl group, an alkoxy group or an amido group, R⁴ and R⁵ are the same or different selected from alkyl groups and alkoxy groups, R^{4a} and R^{5a} are the same or different selected from alkoxy groups and amido groups, R^{4b} is an alkyl or alkoxide group, R^{5b} is an alkyl group, R^{6a} is a H, substituting alkyl group or amido group of the Cp ligand and M is hafnium or zirconium; and excluding the compound bis(cyclopentadienyl) bis(methoxy) hafnium.

In one preferred embodiment the precursor used in the first aspect of the invention is bis(methylcyclopentadienyl) hafnium (IV) dimethyl, (MeCp)₂HfMe₂. This compound has been found to be a low melting point solid with slightly higher volatility than the above-mentioned prior art precursors. Bis(methylcyclopentadienyl) zirconium (IV) dimethyl, (MeCp)₂ZrMe₂, is an example of a preferred zirconium oxide precursor. An alternative is bis(methylcyclopentadienyl) hafnium (IV) methyl ethyl, (MeCp)₂HfMe(Et).

A second aspect of the present invention provides novel precursors suitable for chemical vapour deposition, especially ALD of hafnium oxide or zirconium oxide, wherein the precursor is bis(methylcyclopentadienyl) hafnium (IV) methyl ethyl or bis(methylcyclopentadienyl) zirconium (IV) methyl ethyl or has the general formula:

Cp₂MR^{4a}R^{5a} or (R^{6a}Cp)₂MR^{4b}OR^{5b}

wherein Cp represents a cyclopentadienyl ligand, R^{4a} and R^{5a} are the same or different and selected from an alkoxy group and amido group, R^{4b} is an alkyl or alkoxide group, R^{5b} is an alkyl group, R^{6a} is a H, substituting alkyl group or amido group of the Cp ligand, and M is hafnium or zirconium;
excluding the compounds bis(cyclopentadienyl)bis(methoxy) zirconium (IV), bis(cyclopentadienyl)bis(ethoxy) zirconium (IV), bis(cyclopentadienyl)methyl (methoxy) zirconium (IV), bis(cyclopentadienyl) bis(methoxy) hafnium (IV), bis(cyclopentadienyl) bis(i-propoxy) hafnium (IV), bis(cyclopentadienyl) bis(i-propoxy) zirconium (IV), bis(cyclopentadienyl) zirconium (IV) methyl t-butoxy, bis(methylcyclopentadienyl) zirconium (IV) methyl t-butoxy, bis(n-propylcyclopentadienyl) bis(methoxy) hafnium (IV), and bis(n-propylcyclopentadienyl) bis(methoxy) zirconium (IV).

When the precursor is a compound having the general formula Cp₂MR^{4a}R^{5a}, preferably the precursor contains at least one alkoxide ligand. Preferred precursors of this formula are when R^{4a} and R^{5a} are the same.

When the precursor is a compound having the general formula (R^{6a}Cp)₂MR^{4b}OR^{5b}, preferably the R^{4b} and R^{5b} ligands have 1 to 4 carbon atoms, especially 1 or 2, ideally 1. R^{6a} is preferably H or an alkyl group having 1 or 2 carbon atoms, especially Me.

Preferred precursors include those where R^{4b} is an alkoxide group, particularly bis(methylcyclopentadienyl)bis(methoxy) hafnium (IV), (MeCp)₂Hf(OMe)₂, and its equivalent zirconium components. Alternatively, preferred precursors are those that contain three different ligands, i.e., having the formula:

(R^{6a}Cp)₂MR⁴⁶OR^{5b}

as defined above but wherein R⁴⁶ is not an alkoxide group, particularly bis(methylcyclopentadienyl)methyl methoxy hafnium (IV), (MeCp)₂Hf(OMe)Me wherein Me represents a methyl group and the equivalent zirconium components.

Deposition of hafnium oxide or zirconium oxide from precursors according to the second aspect of the invention is preferably by means of ALD but other deposition techniques, wherein two reactant sources are delivered to a substrate in a controlled sequence, may be used, such as atomic vapour deposition (AVD) and atomic layer epitaxy (ALE). Typically the precursor may be delivered to a substrate in pulses alternating with pulses of a suitable oxygen source, such as H₂O, O₂ or ozone.

The precursor may be delivered to the substrate by any suitable means, examples of which include conventional bubbling of carrier gas, vapour draw or other techniques using neat compounds. Alternatively compound solutions may be prepared and injected into evaporators to put them in the vapour phase for delivery to a growth chamber.

It is envisaged that ALD using this precursor will be suitable for applications such as DRAM and CMOS for memory and logic applications in silicon chips.

This invention will be further described by means of the accompanying drawings, in which:
Figure 1 shows TGA data for purified (MeCp)₂HfMe₂;
Figure 2 is a vapour pressure plot for dimethylhafnocene derivatives;
Figures 3 and 3a are plots of growth rate as a function of deposition temperature for deposition from (CpMe)₂HfMe₂ with O₃ and H₂O;
Figures 4 and 4a are plots of growth rate as a function of (CpMe)₂HfMe₂ pulse length at deposition temperature of 350° (and 400°C) using water and ozone as oxygen sources;
Figure 5 is a plot of growth rate (mm/cycle) versus growth temperature (°C) for atomic layer deposition using HfCp₂Me₂ and (MeCp)₂HfMe₂;
Figure 6 shows proton NMR for Cp₂Hf(OMe)₂;
Figure 7 shows proton NMR for (MeCp)₂Hf(OMe)Me; and
Figure 8 is a comparison of TGA data for various Hf precursors; and
Figures 9 and 10 are plots of growth rate using (MeCp)₂Hf(OMe)Me as a function of deposition temperature (°C) and pulse length (sec), using ozone as the oxygen source.

This invention will now be further described by means of the following Examples.

### Example 1

### Preparation of bis(methylcyclopentadienyl) hafnium (IV) dimethyl, (MeCp)₂HfMe₂

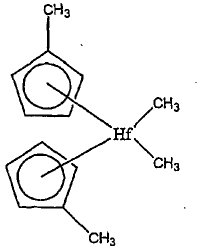

(MeCp)₂HfMe₂ was prepared in a one-pot method as follows. The reaction of 2 equivalents of methylcyclopentadiene with 4 equivalents of MeLi solution in Et₂O, followed by the treatment with 1 equivalent of HfCl₄ gave brown liquid crude product in 87% yield. The product was purified by vacuum distillation of crude product at 80 120°C/0.3 - 0.5 torr (40.0 - 66.7 Pa) to give a wax-like compound (68%). Melting point ~30-40°C. Elemental analysis of this compound was in good agreement with theory (%): C : 45.40 (cal: 45.80); H: 5.40 (cal: 5.45).

Note the reaction scale was targeted to yield 100g of purified product. Increased batch size may be achieved by directly scaling quantities and using appropriately sized equipment.

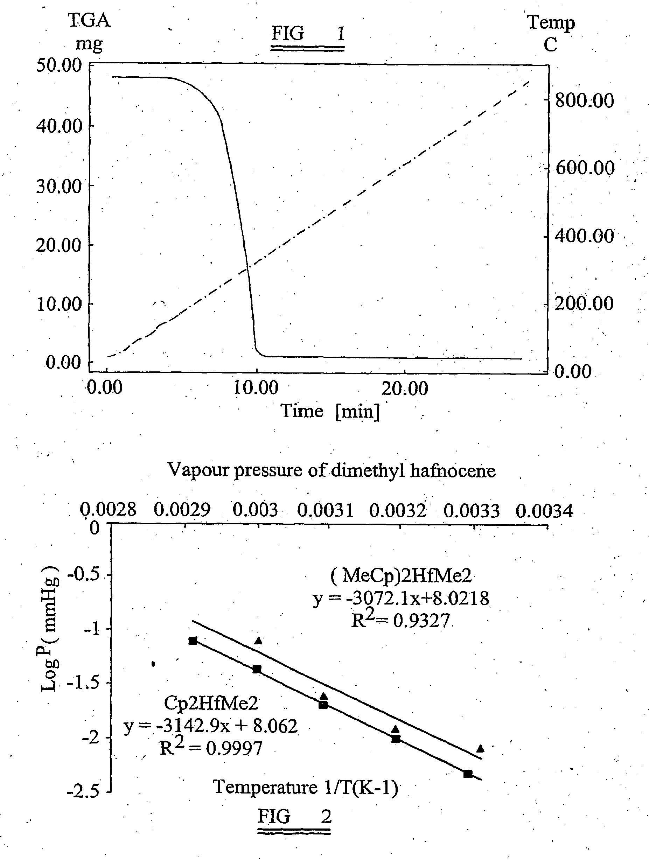

Thermal behaviour of the product was tested with a thermal gravimetric analyzer (TGA) with temperature increases of 20°C/min and 40°C/min. The graph (Figure 1) showed that purified (MeCp)₂HfMe₂ started to vapourise at 50°C and finish at 300°C with less than 4% non-volatile residues.

The vapour pressure of (MeCp)₂HfMe₂ was tested in the temperature range of 30°C to 70°C and the plot is in the following Figure 2, which compares the known source Cp₂HfMe₂ with (MeCp)₂HfMe₂ and shows a beneficial improvement in volatility for the compound, (MeCp)₂HfMe₂.

### Example 2

### Report on ALD studies on (MeCp)₂HfMe₂

The equipment used was a standard ALD reactor (Microchemistry F-120) operating at a pressure of 2-3 mbar (200 - 300 Pa). The (MeCp)₂HfMe₂ precursor was observed to melt at 43-44°C under these conditions and could be suitably evaporated at about 60°C to allow controlled introduction to the growth chamber.

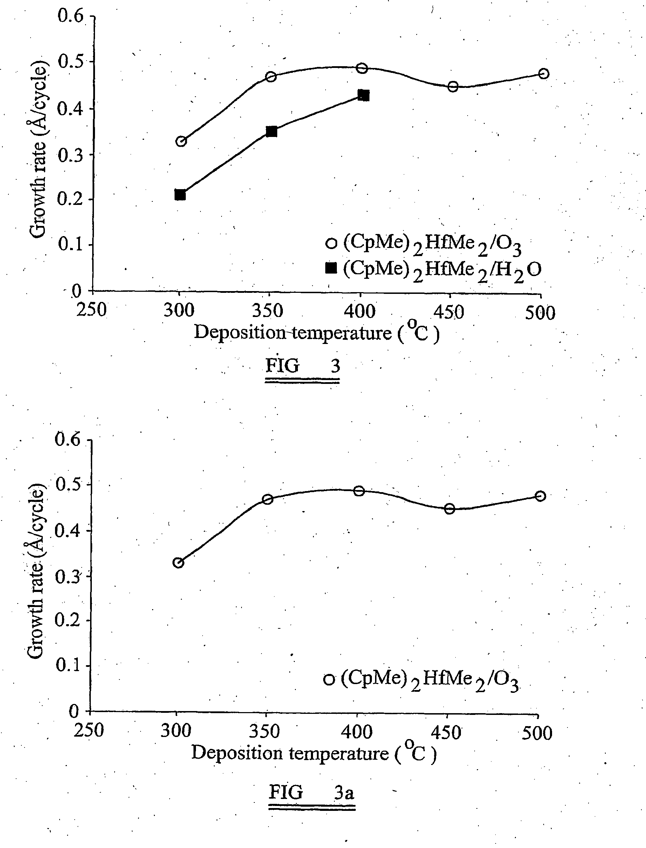

Several runs have been performed to deposit on Si(100) with H₂O and O₃ as the oxygen source. Growth rate against deposition temperature is shown in Figures 3 and 3a.

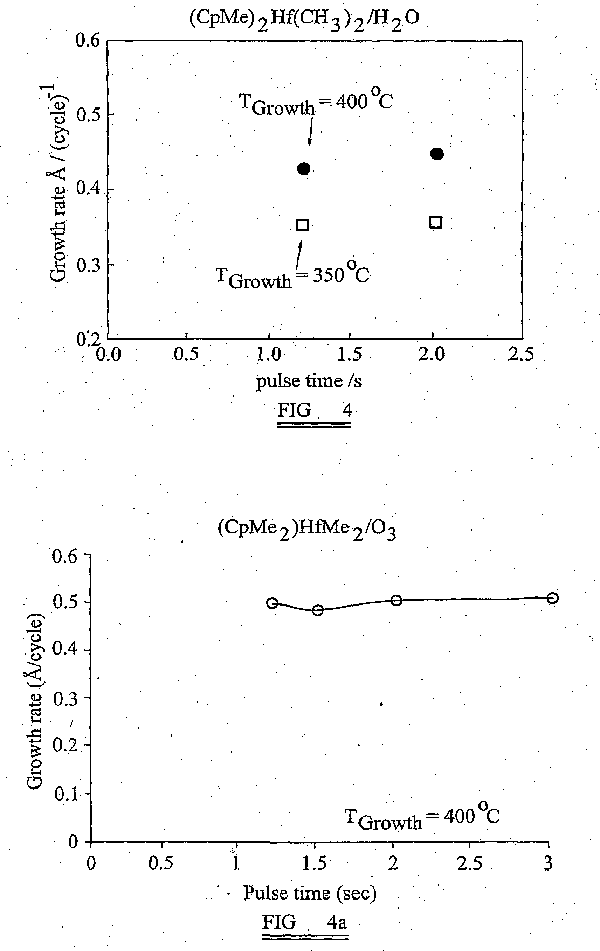

Growth rate at 350°C is 0.36 Å/cycle (0.036nm/cycle), which is slightly lower than with Cp₂HfMe₂/H₂O process (Niinistö J. et al. J. Mater. Chem. 2005). Films could be grown at 300°C but growth rate is rather low. At 350°C and 400°C the ALD type saturative growth seems to be dominant as shown in Figures 4 and 4a.

Uniformity was good (+- 1 nm) over the substrate are (5 x 10 cm²) for all trials.

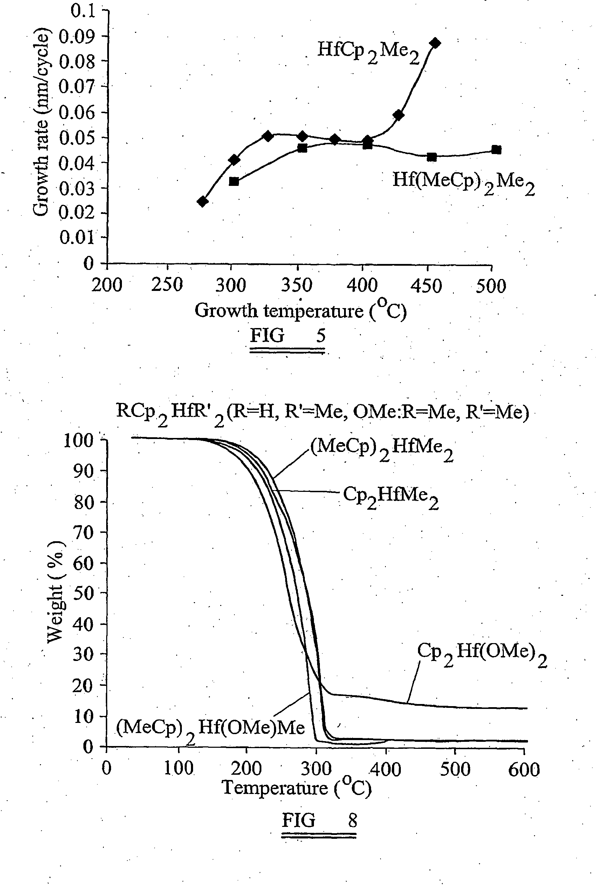

Figure 5 is a plot of ALD performance for Cp₂HfMe₂ and (MeCp)₂HfMe₂. It is clear that the addition of a methyl group to the Cp ring has a profound effect on the temperature range over which the ALD self-limiting growth process holds true. For the prior art compound Cp₂HfMe₂, the self-limiting regime ends around 400°C as demonstrated by a steep rise in growth. In contrast, (MeCp)₂HfMe₂ clearly remains self-limiting up to 500°C. This dramatic change observed with this precursor for ALD was not expected.

### Example 3

### Preparation of bis(cyclopentadienyl)bis(methoxy) hafnium (IV), (Cp)₂Hf(OMe)₂

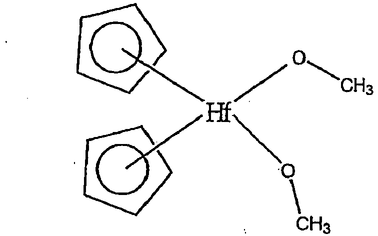

Synthesis of this compound involved a two stage process starting from hafnium tetra-amide and substituting first the Cp and then alkoxide groups as follows. Hf(NMe₂)₄ (58g, 0.16mol) was dissolved in toluene (500mls), and CpH (27mls, 0.41mol) was added and the mixture heated to reflux for 2 hours. Another 20mls of CpH was added and the mixture reheated to reflux for another 2 hours. An aliquot was taken for NMR, which showed the right integrations for Cp₂Hf(NMe₂)₂. The solvent was removed to give a yellow/brown solid in 60g (94%) yield.

Cp₂Hf(NMe₂)₂ (30g, 0.075mol) was dissolved in toluene (250mls) and MeOH (6mls, 4.8g, 0.15mol) added slowly. The solution was heated to reflux for 2 hours then the solvent removed under vacuum to give a dark brown oil. The oil was dried under vacuum, which then became a very thick immobile oil. The product was extracted in toluene and transferred to a sublimation flask. The solvent was removed under vacuum and the product sublimed onto a cold finger.

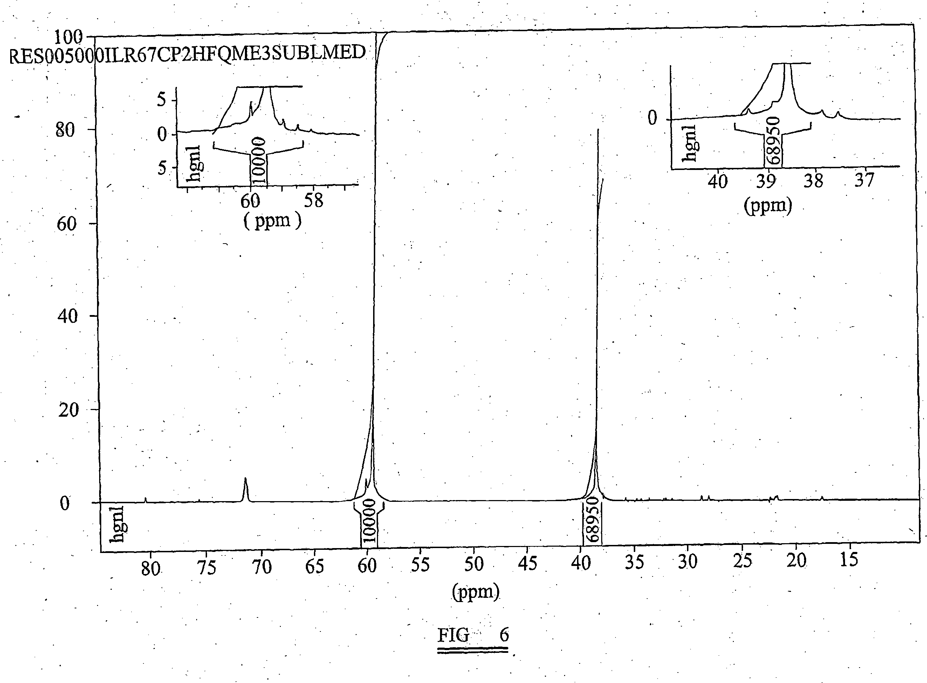

A white crystalline solid was collected at 60-70°C @ 0.5 torr (66.7 Pa). ¹H NMR analysis of the crystals showed only the 2 major peaks expected for Cp₂Hf(OMe)₂ (Figure 6).

### Example 4

### Preparation of bis(methylcyclopentadienyl)methylmethoxy hafnium (IV), (McCp)₂Hf(OMe)Me

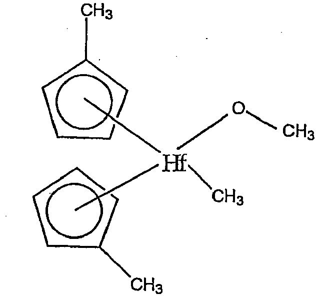

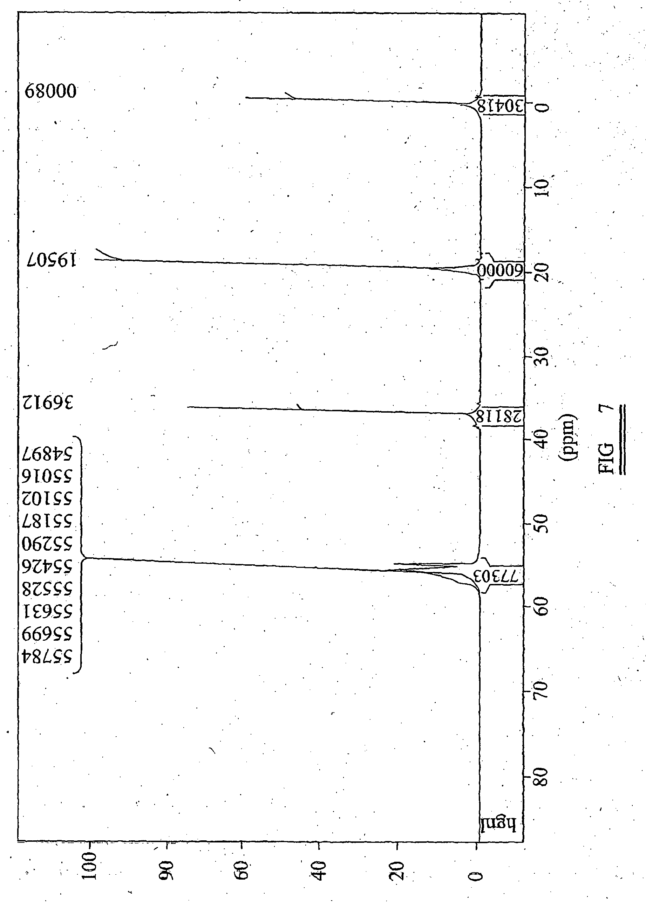

9.3g (0.025 moles) of (Me-Cp)₂HfMe₂ was dissolved in 60 ml of toluene. 2.2ml (0.052 moles) of anhydrous methanol was added. The reaction was stirred overnight and volatiles removed *in vacuo:*
Yield: 9.6g (96%) yellow liquid.
Elemental Analysis: Calc C, 43.93 H, 5.27; Found C, 43.53 H, 5.24. NMR see Figure 7. The peaks observed are as expected for the product.

It should be noted that further addition of methanol did not change the product and full substitution of the alkoxide for the alkyl group could not be achieved by this method.

The liquid nature of this precursor results in it being much more suited to the vapour delivery approach commonly employed in ALD compared with prior art precursors.

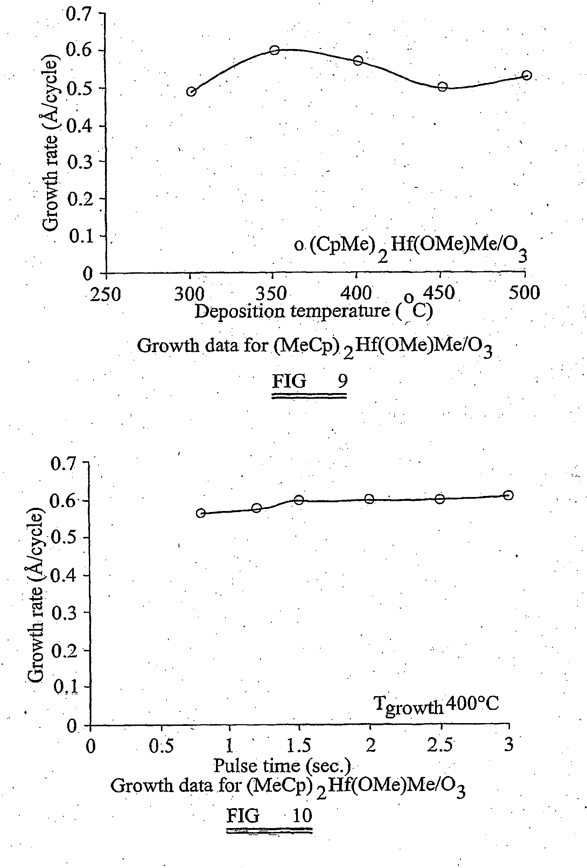

Figures 9 and 10 illustrate the growth data for this precursor against the deposition temperature (°C) and pulse time (sec) respectively.

### Example 5

### Comparison of TGA data.

A comparison of TGA data for a number of compounds is given in Figure 8 to highlight the improvements achieved by molecular tailoring. The MeCp derivatives are clearly superior to unsubstituted Cp compounds with much reduced residues implying greater thermal stability and the ability to vapourise without decomposition.

It is expected that other substituted Cp derivatives in combination with different alkoxide and alkyl groups will have similar properties and by careful choice of the precise groups involved optimised precursors can be isolated for each deposition process.

## Claims

1. The use of a precursor in atomic layer deposition of hafnium oxide or zirconium oxide, wherein the precursor has the general formula:
(R¹Cp)₂M(R)₂ or (R⁶Cp)₂MR⁴R⁵ or Cp₂MR^{4a}R^{sa} or (R^{6a}Cp)₂MR^{4b}OR^{5b}
wherein Cp represents a cyclopentadienyl ligand, R¹ and R⁶ represent a substituting alkyl group, alkoxy group or amido group of the Cp ligand, R is an alkyl group, an alkoxy group or an amido group, R⁴ and R⁵ are the same or different selected from alkyl groups and alkoxy groups, R^{4a} and R^{5a} are the same or different selected from alkoxy groups and amido groups, R^{4b} is an alkyl or an alkoxide group, R^{5b} is an alkyl group, R^{6a} is a H, substituting alkyl group or amido group of the Cp ligand and M is hafnium or zirconium;
excluding the compound bis(cyclopentadienyl) bis(methoxy) hafnium.

2. The use of a precursor as claimed in claim 1, wherein the precursor is bis(methylcyclopentadienyl) hafnium (IV) dimethyl.

3. The use of a precursor as claimed in claim 1, wherein the precursor is bis(methylcyclopentadienyl) zirconium (IV) dimethyl.

4. The use of a precursor as claimed in claim 1, wherein the precursor is bis(methylcyclopentadienyl) hafnium (IV) methyl ethyl.

5. The use of a precursor as claimed in claim 1, wherein the precursor is bis(methylcyclopentadienyl) zirconium (IV) methyl ethyl.

6. The use of a precursor as claimed in claim 1, wherein the precursor is bis(cyclopentadienyl)bis(methoxy) zirconium (IV).

7. The use of a precursor as claimed in claim 1, wherein the precursor is bis(methylcyclopentadienyl)bis(methoxy) hafnium (IV).

8. The use of a precursor as claimed in claim 1, wherein the precursor is bis(methylcyclopentadienyl)bis(methoxy) zirconium (IV).

9. The use of a precursor as claimed in claim 1, wherein the precursor is bis(methylcyclopentadienyl)methyl methoxy hafnium (IV).

10. The use of a precursor as claimed in claim 1, wherein the precursor is bis(methylcyclopentadienyl)methyl methoxy zirconium (IV).

11. A precursor suitable for atomic layer deposition of hafnium oxide or zirconium oxide, wherein the precursor is bis(methylcyclopentadienyl) hafnium (IV) methyl ethyl or bis(methylcyclopentadienyl) zirconium (IV) methyl ethyl or has the general formula:
Cp₂MR^{4a}R^{5a} or (R^{6a}Cp)₂MR^{4b}OR^{5b}
wherein Cp represents a cyclopentadienyl ligand, R^{4a} and R^{5a} are the same or different and selected from an alkoxy group and amido group, R^{4b} is an alkyl or alkoxide group, R^{5b} is an alkyl group, R^{6a} is a H, substituting alkyl group or amido group of the Cp ligand, and M is hafnium or zirconium;
excluding the compounds bis(cyclopentadienyl)bis(methoxy)zirconium (IV), bis(cyclopentadienyl)bis(ethoxy) zirconium (IV), bis(cyclopentadienyl)methyl (methoxy) zirconium (IV), bis(cyclopentadienyl) bis(methoxy) hafnium (IV), bis(cyclopentadienyl) bis(i-propoxy) hafnium (IV), bis(cyclopentadienyl) bis (i-propoxy) zirconium (IV), bis(cyclopentadienyl) zirconium (IV) methyl t-butoxy, bis(methylcyclopentadienyl) zirconium (IV) methyl t-butoxy, bis(n-propylcyclopentadienyl) bis(methoxy) hafnium (IV), and bis(n-propylcyclopentadienyl) bis(methoxy) zirconium (IV).

12. The precursor as claimed in claim 11, wherein the precursor is selected from the group consisting of bis(methylcyclopentadienyl) hafnium (IV) methyl ethyl, bis(methylcyclopentadienyl) zirconium (IV) methyl ethyl, bis(methylcyclopentadienyl) bis(methoxy) hafnium (IV), bis(methylcyclopentadienyl) bis(methoxy) zirconium (IV), bis(methylcyclopentadienyl) methyl methoxy hafnium (IV), and bis(methylcyclopentadienyl) methyl methoxy zirconium (IV).

13. The precursor as claimed in claim 11, wherein R^{6a} is a substituting alkyl group and R^{4b} is an alkoxide group.

14. The precursor as claimed in claim 11, wherein R^{6a} is an alkyl group and R^{4b} is an alkyl group.

15. A method of depositing hafnium oxide or zirconium oxide by ALD, the method comprising using a precursor as claimed in any one of claims 11 to 14.

16. The use as claimed in any one of claims 1 to 10 or the method as claimed in claim 15, wherein the precursor is delivered to a substrate in pulses alternating with pulses of an oxygen source.

17. The use or method as claimed in claim 16, wherein the oxygen source is selected from H₂O, O₂ and ozone.

18. The use as claimed in any one of claims 1 to 10, 16 and 17, or the method as claimed in claim 15, 16 or 17, wherein the precursor is delivered to the substrate by bubbling of carrier gas, vapour draw or other techniques using neat compounds.

19. The use as claimed in any one of claims 1 to 10, 16 and 17, or the method as claimed in claim 15, 16 or 17, wherein a precursor compound solution is prepared and injected into an evaporator to put the precursor compound solution into the vapour phase for delivery to a growth chamber.

20. The use as claimed in any one of claims to 10, 16 and 17, or the method as claimed in any one of claims 15 to 19 in ALD for applications including DRAM and CMOS for memory and logic applications on silicon chips.

## Patentansprüche

1. Verwendung eines Vorläufers in Atomlagenabscheidung von Hafniumoxid oder Zirkonoxid, wobei der Vorläufer die Allgemeinformel hat:
(R¹Cp)₂M(R)₂ oder (R⁶Cp)₂MR⁴R⁵ oder Cp₂MR^{4a}R^{5a} oder (R^{6a}Cp)₂MR^{4b}OR^{5b}
worin Cp einen Cyclopentadienyl-Liganden darstellt, R¹ und R⁶ eine substituierende Alkylgruppe, Alkoxygruppe oder Amidogruppe des Cp-Liganden darstellen, R eine Alkylgruppe, eine Alkoxygruppe oder eine Amidogruppe ist, R⁴ und R⁵ gleich oder unterschiedlich sind, ausgewählt aus Alkylgruppen und Alkoxygruppen, R^{4a} und R^{5a} gleich oder unterschiedlich sind, ausgewählt aus Alkoxygruppen und Amidogruppen, R^{4b} eine Alkyl- oder eine Alkoxidgruppe ist, R^{5b} eine Alkylgruppe ist, R^{6a} ein H, eine substituierende Alkylgruppe oder Amidogruppe des Cp-Liganden ist und M Hafnium oder Zirkon ist;
ausgenommen die Verbindung Bis(cyclopentadienyl)bis(methoxy)hafnium.

2. Verwendung eines Vorläufers gemäß Anspruch 1, wobei der Vorläufer Bis(methylcyclopentadienyl)hafnium(IV)-dimethyl ist.

3. Verwendung eines Vorläufers gemäß Anspruch 1, wobei der Vorläufer Bis(methylcyclopentadienyl)zirkon(IV)-dimethyl ist.

4. Verwendung eines Vorläufers gemäß Anspruch 1, wobei der Vorläufer Bis(methylcyclopentadienyl)hafnium(IV)-methylethyl ist.

5. Verwendung eines Vorläufers gemäß Anspruch 1, wobei der Vorläufer Bis(methylcyclopentadienyl)zirkon(IV)-methylethyl ist.

6. Verwendung eines Vorläufers gemäß Anspruch 1, wobei der Vorläufer Bis(cyclopentadienyl)bis(methoxy)zirkon(IV) ist.

7. Verwendung eines Vorläufers gemäß Anspruch 1, wobei der Vorläufer Bis(methylcyclopentadienyl)bis(methoxy)hafnium(IV) ist.

8. Verwendung eines Vorläufers gemäß Anspruch 1, wobei der Vorläufer Bis(methylcyclopentadienyl)bis(methoxy)zirkon(IV) ist.

9. Verwendung eines Vorläufers gemäß Anspruch 1, wobei der Vorläufer Bis(methylcyclopentadienyl)methylmethoxyhafnium(IV) ist.

10. Verwendung eines Vorläufers gemäß Anspruch 1, wobei der Vorläufer Bis(methylcyclopentadienyl)methylmethoxyzirkon(IV) ist.

11. Vorläufer, geeignet für Atomlagenabscheidung von Hafniumoxid oder Zirkonoxid, wobei der Vorläufer Bis(methylcyclopentadienyl)hafnium(IV)-methylethyl oder Bis(methylcyclopentadienyl)zirkon(IV)-methylethyl ist oder die Allgemeinformel hat:
Cp₂MR^{4a}R^{5a} oder (R^{6a}Cp)₂MR^{4b}OR^{5b}
worin Cp einen Cyclopentadienyl-Liganden darstellt, R^{4a} und R^{5a} gleich oder unterschiedlich sind und ausgewählt aus einer Alkoxygruppe und einer Amidogruppe, R^{4b} eine Alkyl- oder eine Alkoxidgruppe ist, R^{5b} eine Alkylgruppe ist, R^{6a} ein H, eine substituierende Alkylgruppe oder Amidogruppe des Cp-Liganden ist und M Hafnium oder Zirkon ist;
ausgenommen die Verbindungen Bis(cyclopentadienyl)bis(methoxy)zirkon(IV), Bis(cyclopentadienyl)bis(ethoxy)zirkon(IV), Bis(cyclopentadienyl)methyl-(methoxy)zirkon(IV), Bis(cyclopentadienyl)bis(methoxy)hafnium(IV), Bis(cyclopentadienyl)bis(i-propoxy)hafnium(IV), Bis(cyclopentadienyl)bis(i-propoxy)-zirkon(IV), Bis(cyclopentadienyl)zirkon(IV)-methyl-t-butoxy, Bis(methylcyclopentadienyl)zirkon(IV)-methyl-t-butoxy, Bis(n-propylcyclopentadienyl)bis-(methoxy)hafnium(IV) und Bis(n-propylcyclopentadienyl)bis(methoxy)zirkon(IV).

12. Vorläufer gemäß Anspruch 11, wobei der Vorläufer ausgewählt ist aus der Gruppe Bis(methylcyclopentadienyl)hafnium(IV)-methylethyl, Bis(methylcyclopentadienyl)zirkon(IV)-methylethyl, Bis(methylcyclopentadienyl)bis(methoxy)-hafnium(IV), Bis(methylcyclopentadienyl)bis(methoxy)zirkon(IV), Bis(methylcyclopentadienyl)methylmethoxyhafnium(IV), und Bis(methylcyclopentadienyl)-methylmethoxyzirkon(IV).

13. Vorläufer gemäß Anspruch 11, wobei R^{6a} eine substituierende Alkylgruppe ist und R^{4b} eine Alkoxidgruppe ist.

14. Vorläufer gemäß Anspruch 11, wobei R^{6a} eine Alkylgruppe ist und R^{4b} eine Alkylgruppe ist.

15. Verfahren zum Abscheiden von Hafniumoxid oder Zirkonoxid durch Atomlagenabscheidung, das Verfahren umfassend Verwenden eines Vorläufers gemäß irgendeinem der Ansprüche 11 bis 14.

16. Verwendung gemäß irgendeinem der Ansprüche 1 bis 10 oder Verfahren gemäß Anspruch 15, wobei der Vorläufer einem Substrat in Pulsen zugeführt wird, abwechselnd mit Pulsen einer Sauerstoffquelle.

17. Verwendung oder Verfahren gemäß Anspruch 16, wobei die Sauerstoffquelle ausgewählt ist aus H₂O, O₂ und Ozon.

18. Verwendung gemäß irgendeinem der Ansprüche 1 bis 10, 16 und 17 oder Verfahren gemäß Anspruch 15, 16 oder 17, wobei der Vorläufer dem Substrat zugeführt wird durch Blubbern von Trägergas, Dampfabzug oder anderen Techniken mit Hilfe von sauberen Verbindungen.

19. Verwendung gemäß irgendeinem der Ansprüche 1 bis 10, 16 oder 17 oder Verfahren gemäß Anspruch 15, 16 oder 17, wobei eine Lösung einer Vorläuferverbindung hergestellt wird und in einen Verdampfer injiziert zum Auflösen der Vorläuferverbindung in der Dampfphase zum Zuführen in eine Wachstumskammer.

20. Verwendung gemäß irgendeinem der Ansprüche 1 bis 10, 16 und 17 oder Verfahren gemäß irgendeinem der Ansprüche 15 bis 19 in einer Atomlagenabscheidung für Anwendungen, einschließlich DRAM und CMOS für Speicher- und Logikanwendungen auf Siliciumchips.

## Revendications

1. L'utilisation d'un précurseur dans un dépôt de couche atomique d'oxyde de hafnium ou d'oxyde de zirconium, où le précurseur possède la formule générale suivante :
(R¹Cp)₂M(R)₂ ou (R⁶Cp)₂MR⁴R⁵ ou Cp₂MR^{4a}R^{5a} ou (R^{6a}Cp)₂MR^{4b}OR^{5b}
où Cp représente un ligand cyclopentadiényle, R¹ et R⁶ représentent un groupe alkyle, un groupe alkoxy ou un groupe amido de substitution du ligand Cp, R est un groupe alkyle, un groupe alkoxy ou un groupe amido, R⁴ et R⁵ sont le même groupe ou des groupes différents sélectionnés parmi des groupes alkyle et des groupes alkoxy, R^{4a} et R^{5a} sont le même groupe ou des groupes différents sélectionnés parmi des groupes alkoxy et des groupes amido, R^{4b} est un alkyle ou un groupe alkoxyde, R^{5b} est un groupe alkyle, R^{6a} est un H, un groupe alkyle ou un groupe amido de substitution du ligand Cp et M est hafnium ou zirconium, à l'exclusion du composé bis(cyclopentadiényle) bis(méthoxy) hafnium.

2. L'utilisation d'un précurseur selon la revendication 1, où le précurseur est bis(méthylecyclopentadiényle) hafnium (IV) diméthyle.

3. L'utilisation d'un précurseur selon la revendication 1, où le précurseur est bis(méthylecyclopentadiényle) zirconium (IV) diméthyle.

4. L'utilisation d'un précurseur selon la revendication 1, où le précurseur est bis(méthylecyclopentadiényle) hafnium (IV) méthyle éthyle.

5. L'utilisation d'un précurseur selon la revendication 1, où le précurseur est bis(méthylecyclopentadiényle) zirconium (IV) méthyle éthyle.

6. L'utilisation d'un précurseur selon la revendication 1, où le précurseur est bis(cyclopentadiényle) bis(méthoxy) zirconium (IV).

7. L'utilisation d'un précurseur selon la revendication 1, où le précurseur est bis(méthylecyclopentadiényle) bis(méthoxy) hafnium (IV).

8. L'utilisation d'un précurseur selon la revendication 1, où le précurseur est bis(méthylecyclopentadiényle) bis(méthoxy) zirconium (IV).

9. L'utilisation d'un précurseur selon la revendication 1, où le précurseur est bis(méthylecyclopentadiényle)méthyle méthoxy hafnium (IV).

10. L'utilisation d'un précurseur selon la revendication 1, où le précurseur est bis(méthylecyclopentadiényle)méthyle méthoxy zirconium (IV).

11. Un précurseur conçu pour un dépôt de couche atomique d'oxyde de hafnium ou d'oxyde de zirconium, où le précurseur est bis(méthylecyclopentadiényle) hafnium (IV) méthyle éthyle ou bis(méthylecyclopentadiényle) zirconium (IV) méthyle éthyle ou possède la formule générale suivante :
Cp₂MR^{4a}R^{5a} ou (R^{6a}Cp)₂MR^{4b}OR^{5b}
où Cp représente un ligand cyclopentadiényle, R^{4a} et R^{5a} sont le même groupe ou des groupes différents et sélectionnés parmi un groupe alkoxy et un groupe amido, R^{4b} est un alkyle ou groupe alkoxyde, R^{5b} est un groupe alkyle, R^{6a} est un H, un groupe alkyle ou un groupe amido de substitution du ligand Cp, et M est hafnium ou zirconium,
à l'exclusion des composés bis(cyclopentadiényle)bis(méthoxy)zirconium (IV), bis(cyclopentadiényle)bis(éthoxy) zirconium (IV), bis(cyclopentadiényle)méthyle (méthoxy) zirconium (IV), bis(cyclopentadiényle) bis(méthoxy) hafnium (IV), bis-(cyclopentadiényle) bis(i-propoxy) hafnium (IV), bis(cyclopentadiényle) bis(i-propoxy) zirconium (IV), bis(cyclopentadiényle) zirconium (IV) méthyle t-butoxy, bis(méthylecyclopentadiényle) zirconium (IV) méthyle t-butoxy, bis(n- propylecyclopentadiényle) bis(méthoxy) hafnium (IV), et bis(n- propylecyclopentadiényle) bis(méthoxy) zirconium (IV).

12. Le précurseur selon la revendication 11, où le précurseur est sélectionné dans le groupe se composant de bis(méthylecyclopentadiényle) hafnium (IV) méthyle éthyle, bis(méthylecyclopentadiényle) zirconium (IV) méthyle éthyle, bis(méthylecyclopentadiényle) bis(méthoxy) hafnium (IV), bis(méthylecyclopentadiényle) bis-(méthoxy) zirconium (IV), bis(méthylecyclopentadiényle) méthyle méthoxy hafnium (IV) et bis(méthylecyclopentadiényle) méthyle méthoxy zirconium (IV).

13. Le précurseur selon la revendication 11, où R^{6a} est un groupe alkyle de substitution et R^{4b} est un groupe alkoxyde.

14. Le précurseur selon la revendication 11, où R^{6a} est un groupe alkyle et R^{4b} est un groupe alkyle.

15. Un procédé de dépôt d'oxyde de hafnium ou d'oxyde de zirconium par ALD, le procédé comprenant l'utilisation d'un précurseur selon l'une quelconque des revendications 11 à 14.

16. L'utilisation selon l'une quelconque des revendications 1 à 10 ou le procédé selon la revendication 15, où le précurseur est distribué à un substrat par des impulsions alternant avec des impulsions d'une source d'oxygène.

17. L'utilisation ou le procédé selon la revendication 16, où la source d'oxygène est sélectionnée parmi H₂O, O₂ et ozone.

18. L'utilisation selon l'une quelconque des revendications 1 à 10, 16 et 17, ou le procédé selon la revendication 15, 16 ou 17, où le précurseur est distribué au substrat par barbotage d'un gaz porteur, tirage en phase vapeur ou d'autres techniques utilisant des composés purs.

19. L'utilisation selon l'une quelconque des revendications 1 à 10, 16 et 17, ou le procédé selon la Revendication 15, 16 ou 17, où une solution de composé précurseur est préparée et injectée dans un évaporateur de façon à placer la solution de composé précurseur en phase vapeur pour distribution à une chambre de culture.

20. L'utilisation selon l'une quelconque des revendications 1 à 10, 16 et 17 ou le procédé selon l'une quelconque des revendications 15 à 19 dans ALD pour des applications comprenant DRAM et CMOS pour des applications de mémoire et de logique sur des puces de silicium.
